(19) Europäisches Patentamt / European Patent Office / Office européen des brevets

(11) **EP 3 032 598 B1**

(12) **FASCICULE DE BREVET EUROPEEN**

(45) Date de publication et mention de la délivrance du brevet:
**04.05.2022 Bulletin 2022/18**

(21) Numéro de dépôt: **15198780.7**

(22) Date de dépôt: **09.12.2015**

(51) Classification Internationale des Brevets (IPC):
**H01L 49/02** *(2006.01)*    **H01G 4/33** *(2006.01)*
**H01L 45/00** *(2006.01)*    **H01G 7/06** *(2006.01)*

(52) Classification Coopérative des Brevets (CPC):
**H01G 7/06; H01G 4/33; H01L 28/75;** H01L 45/06;
H01L 45/085; H01L 45/1233; H01L 45/144;
H01L 45/146

(54) **CONDENSATEUR À CAPACITÉ VARIABLE COMPRENANT UNE COUCHE DE MATÉRIAU À CHANGEMENT D'ÉTAT ET UN PROCÉDÉ DE VARIATION D'UNE CAPACITÉ D'UN CONDENSATEUR**

**KONDENSATOR MIT VARIABLER KAPAZITÄT, DER EINE MATERIALSCHICHT MIT ZUSTANDSVERÄNDERUNG UMFASST, UND VERFAHREN ZUR VARIATION DER KAPAZITÄT EINES KONDENSATORS**

**VARIABLE CAPACITANCE CAPACITOR COMPRISING A LAYER OF STATE CHANGE MATERIAL AND METHOD FOR VARYING A CAPACITANCE OF A CAPACITOR**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.12.2014 FR 1462194**

(43) Date de publication de la demande:
**15.06.2016 Bulletin 2016/24**

(73) Titulaire: **COMMISSARIAT À L'ÉNERGIE ATOMIQUE ET AUX ÉNERGIES ALTERNATIVES
75015 Paris (FR)**

(72) Inventeurs:
• **REIG, Bruno
  38430 MOIRANS (FR)**
• **BASTIEN, Jean-Claude
  29470 PLOUGASTEL DAOULAS (FR)**

(74) Mandataire: **Brizio Delaporte, Allison
  Cabinet Hautier
  20, rue de la Liberté
  06000 Nice (FR)**

(56) Documents cités:
**WO-A1-2009/128048**

## Description

### DOMAINE TECHNIQUE

La présente invention concerne un condensateur à capacité variable comprenant un matériau à changement d'état résistif et un procédé de variation de la capacité.

L'invention trouvera son application dans le domaine de la micro-électronique ce qui comprend les nanotechnologies et notamment dans des applications nécessitant des composants dont les propriétés appartiennent au domaine de la micro-électronique et plus particulièrement dans des applications nécessitant des composants dont les propriétés peuvent être modifiées en fonction du besoin.

### ETAT DE LA TECHNIQUE

L'industrie de la microélectronique est soumise à des contraintes importantes de miniaturisation afin de réaliser des circuits de plus en plus complexes dans un encombrement de plus en plus réduit. Par exemple pour répondre aux besoins de la téléphonie mobile il est nécessaire de réaliser des circuits permettant de commuter entre les différentes fonctions du téléphone (téléphonie sur différentes bandes de fréquences, réseau local, internet,...) sans augmenter la taille de l'appareil.

On connaît de US-B1-6,977,198 des condensateurs métal-isolant-métal réalisés en alternant des couches de métaux et d'isolants permettant de mettre deux condensateurs ayant une électrode commune en parallèle afin d'obtenir une valeur de capacité plus importante sur une surface équivalente. Ces condensateurs ne permettent pas de faire varier la valeur de la capacité.

Afin de faire face à cette demande, il est nécessaire de développer des composants variables dont les propriétés peuvent être modifiées en fonction du besoin. Dans ce contexte, les capacités variables sont un élément essentiel du développement des circuits électroniques et en particulier des circuits RF (Radio Fréquences).

On connaît les capacités commutées sous forme de Microsystèmes électromécaniques (MEMS). Dans une capacité commutée MEMS telle que décrite dans US-A1-2012/0280393, ou bien dans le document WO2009/128048 divulguant un dispositif MEMS comprenant au moins un cantilever pliable, une couche à changement de phase et des électrodes, deux états de capacités peuvent être obtenus en appliquant un signal de commande électrostatique permettant de déplacer une électrode suspendue de la capacité. Le déplacement de cette électrode permet de faire varier l'espacement inter-électrode de la capacité modifiant ainsi la valeur de la capacité. Un tel dispositif fait appel à une conception électromécanique complexe et doit être protégé par un packaging afin de pouvoir garantir sa fiabilité.

On connait des empilements Metal Oxyde Semiconducteur (MOS) et des diodes varactor (de l'anglais variable reactor) à capacité variable ou bien des empilements avec deux électrodes enchâssant un matériau de type ferroélectrique dont la constante diélectrique peut être modifiée de façon continue entre deux valeurs en lui appliquant un champ diélectrique externe. Dans ces trois dispositifs, la capacité peut être modifiée de façon continue entre deux valeurs, mais une tension de courant continu doit rester appliquée pour maintenir une valeur de capacité.

Il existe donc le besoin de proposer un condensateur à capacité variable qui soit facilement intégrable au sein des circuits micro-électronique et de préférence nécessitant peu de puissance pour fonctionner.

### RÉSUMÉ DE L'INVENTION

La présente invention propose à cet effet un condensateur à capacité variable qui peut être basé sur le principe d'une capacité MIM (Métal-isolant-Métal) intégrant un matériau à changement d'état afin de pouvoir faire varier la valeur de la capacité.

Le condensateur selon l'invention est défini par la revendication 1, et comprend en particulier une première et une deuxième électrode en regard l'une de l'autre et espacées par un matériau diélectrique. La deuxième électrode est formée d'une part d'une électrode primaire en matériau conducteur électriquement et d'autre part d'une électrode additionnelle comprenant un matériau à changement d'état. L'électrode primaire et l'électrode additionnelle sont respectivement en regard de la première électrode. Ce placement en regard de la deuxième électrode est suivant une orientation fixe relativement à la première électrode. Le matériau à changement d'état est au moins partiellement disposé au contact de l'électrode primaire. Le matériau à changement d'état est configuré pour prendre alternativement un état fortement résistif et un état faiblement résistif. Dans l'état faiblement résistif, le matériau à changement d'état est conducteur se mettant en conduction électrique avec l'électrode primaire. Dans l'état fortement résistif, le matériau à changement d'état est résistant de sorte à isoler l'électrode primaire. La surface électriquement active de la deuxième électrode est différente selon l'état du matériau à changement d'état. Ce changement de surface électriquement active entraîne une variation de la capacité du condensateur.

De cette manière, lorsque le matériau à changement d'état est dans un état fortement résistif, la surface électriquement active de la deuxième électrode en regard de la première électrode correspond à la surface de l'électrode primaire en regard de la première électrode. Lorsque le matériau à changement d'état est dans un état faiblement résistif, la surface électriquement active de la deuxième électrode correspondant à la somme des surfaces de l'électrode primaire et de l'électrode additionnelle en regard de la première électrode.

L'invention ne comporte aucun élément mobile pour faire varier notablement la capacité, il ne nécessite donc pas d'environnement adapté. Ce placement en regard de la deuxième électrode est suivant une orientation fixe relativement à la première électrode. Ainsi, il n'y a pas de changement de position relative en inclinaison entre la surface active de la première électrode et celle de la deuxième. L'angle formé par ces surfaces est constant durant le fonctionnement du condensateur. Cet aspect permet d'assurer une grande fiabilité dans le fonctionnement dans la mesure où d'éventuelles déformations de la deuxième électrode, par exemple à cause des changements d'état du matériau à changement de phase, n'influe pas sur l'orientation relative des électrodes.

Les électrodes sont fixes l'une par rapport à l'autre et notamment la première électrode est fixe relativement à la deuxième électrode et inversement, au moins en flexion suivant un sens de rapprochement ou d'éloignement desdites électrodes. On entend par cette fixité que la variation de la surface active de la deuxième électrode n'est pas due à une mobilité relative de parties des deux électrodes au moins en flexion suivant un sens de rapprochement ou d'éloignement desdites électrodes. Globalement il est avantageux que la projection orthogonale, selon la direction en hauteur de l'empilement, d'une électrode sur l'autre soit fixe en surface, ou variable de manière négligeable quant à l'impact sur la variation de capacité.

Suivant un autre aspect, l'entrefer entre les deux électrodes est fixe, ou de variation négligeable quant à son influence sur une variation de capacité.

Suivant un autre aspect, l'entrefer, s'entendant ici comme l'espace séparant les deux électrodes est de hauteur identique sur au moins une portion de la surface en regard des deux électrodes. Les surfaces en regard des électrodes sont de préférence parallèles. Elles sont avantageusement planes. Ces paramètres s'entendent aux tolérances de fabrication près.

Le condensateur selon l'invention peut prendre au moins deux valeurs de capacité. Le changement entre les différentes valeurs de capacités est obtenu en fonction de l'état du matériau à changement d'état. Avantageusement, le condensateur comprend des moyens de commande configurés pour appliquer un signal de commande adapté au niveau du matériau à changement d'état. Une fois le changement effectué, le matériau à changement d'état reste dans un état stable jusqu'au changement suivant. Préférentiellement, une fois le changement d'état effectué, le signal de commande peut être coupé, le matériau est stable dans son état jusqu'à l'application d'un nouveau signal de commande. Il n'y a donc pas de consommation d'énergie en dehors des phases de changement d'état.

De plus, l'invention utilise des matériaux à changement d'état tels que des matériaux à changement de phase, qui présentent une très bonne compatibilité avec les technologies MOS permettant de réaliser sur une même plaque de silicium le condensateur objet de l'invention et des circuits actifs.

Selon un mode de réalisation préféré, l'électrode additionnelle comprend une couche de matériau conducteur électriquement disposée de sorte à ce que le matériau à changement d'état soit placé entre l'électrode primaire et la couche de matériau conducteur électriquement de l'électrode additionnelle.

L'invention concerne aussi un dispositif comprenant au moins un condensateur selon l'invention et des moyens de commande de l'état du matériau à changement d'état de ce condensateur. Les moyens de commande sont avantageusement configurés pour faire passer ledit matériau d'un état à un autre. D'une manière générale, un des états est plus conducteur d'électricité que l'autre. Un des états est configuré pour permettre une fonction de continuité électrique alors que le deuxième état est configuré pour réaliser une fonction d'isolation électrique, dans l'application souhaitée du condensateur.

Un autre aspect de modes de réalisation de l'invention concerne un condensateur électrique à capacité variable selon la revendication 15, comprenant au moins :

- un premier empilement (empilement n) comportant une première électrode et une deuxième électrode en regard de la première électrode et une zone d'un matériau diélectrique disposée entre lesdites première et deuxième électrodes, premier empilement dans lequel la deuxième électrode est formée pour une part d'une électrode primaire en un matériau électriquement conducteur et, pour une autre part, d'une électrode additionnelle comprenant un matériau à changement d'état, l'électrode primaire et l'électrode additionnelle étant respectivement en regard de la première électrode, suivant une orientation fixe relativement à la première électrode, ledit matériau à changement d'état étant disposé au moins partiellement au contact de l'électrode primaire et configurée pour prendre alternativement un état fortement résistif dans lequel l'électrode additionnelle est isolée électriquement de l'électrode primaire et un état faiblement résistif dans lequel l'électrode additionnelle est en conduction électrique avec l'électrode primaire de sorte à faire varier la surface électriquement active de la deuxième électrode,

- un deuxième empilement (empilement n+1) comprenant une troisième électrode et une quatrième électrode en regard de la troisième électrode et une zone d'un matériau diélectrique disposée entre lesdites troisième et quatrième électrodes, la quatrième électrode est formée pour une part d'une électrode primaire en un matériau électriquement conducteur et, pour une autre part, d'une électrode additionnelle comprenant un matériau à changement d'état de deuxième empilement, l'électrode primaire et l'électrode additionnelle de la quatrième électrode étant respectivement en regard de la troisième électrode, ledit matériau à changement d'état du deuxième empilement étant disposé au moins partiellement au contact de l'électrode primaire de la quatrième électrode et étant configurée pour prendre alternativement un état fortement résistif dans lequel l'électrode additionnelle de la troisième électrode est isolée électriquement de l'électrode primaire de la quatrième électrode et un état faiblement résistif dans lequel l'électrode additionnelle de la quatrième électrode est en conduction électrique avec l'électrode primaire de la quatrième électrode de sorte à faire varier la surface électriquement active de la quatrième électrode,

et dans lequel la partie de la première électrode du premier empilement qui est en regard de l'électrode additionnelle du premier empilement forme l'électrode primaire du deuxième empilement,

et dans lequel la deuxième électrode du premier empilement forme une partie de la troisième électrode qui est en regard de l'électrode primaire du deuxième empilement.

L'invention concerne également un condensateur à capacité variable comprenant une pluralité d'empilements tels que décrits ci-dessus. Avantageusement, chaque empilement est réuni avec l'empilement n+1 par la première électrode de l'empilement n qui joue le rôle d'électrode primaire de la deuxième électrode de l'empilement n+1.

Avantageusement, la première électrode l'empilement n+1 est électriquement reliée à la deuxième électrode de l'empilement n.

Est aussi décrit un procédé de variation de la capacité d'un condensateur à capacité variable selon l'invention caractérisé en ce qu'il comprend l'application d'un signal de commande de l'état du matériau à changement d'état d'au moins un empilement de sorte à le faire passer d'un état fortement résistif dans lequel l'électrode additionnelle est isolée électriquement de l'électrode primaire à un état faiblement résistif dans lequel l'électrode additionnelle est en conduction électrique avec l'électrode primaire de sorte à faire varier la surface électriquement active de la deuxième électrode et de fait la capacité du condensateur.

## BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les figures d'accompagnement dans lesquelles :

Figure 1 : Vue en coupe d'un condensateur à capacité variable suivant un premier mode de réalisation.
Figure 2 : Schéma électrique du condensateur illustré à la figure 1.
Figure 3 : Vue en coupe d'un condensateur à capacité variable suivant une première variante du premier mode de réalisation.
Figure 4 : Vue en perspective partiellement éclatée suivant la figure 3.
Figure 5 : Vue en perspective partiellement éclatée d'une deuxième variante de la figure 3.
Figure 6 : Vue en perspective partiellement éclatée d'une troisième variante du premier mode de réalisation.
Figure 7 : Vue en coupe d'un condensateur à capacité variable suivant un deuxième mode de réalisation.
Figure 8 : Vue en coupe d'un condensateur à capacité variable suivant un troisième mode de réalisation.
Figure 9 : Vue en coupe d'un condensateur à capacité variable comprenant deux empilements suivant le premier mode de réalisation.

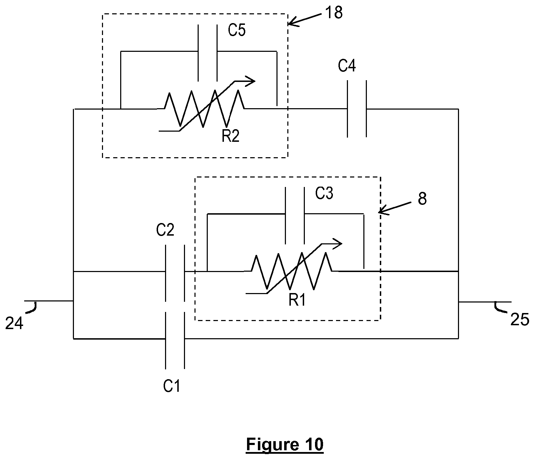

Figure 10 : Schéma électrique du condensateur illustré à la figure 9.

Les dessins joints sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.
En particulier, les épaisseurs relatives des différentes couches et films ne sont pas représentatives de la réalité.

## DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement.
On rappelle tout d'abord que l'invention porte, selon un aspect, sur un condensateur électrique à capacité variable comprenant au moins un premier empilement comprenant une première électrode et une deuxième électrode en regard de la première électrode et une zone d'un matériau diélectrique disposée entre lesdites première et deuxième électrodes caractérisé en que la deuxième électrode est formée pour une part d'une électrode primaire en un matériau électriquement conducteur et, pour une autre part, d'une électrode additionnelle comprenant un matériau à changement d'état, l'électrode primaire et l'électrode additionnelle étant en regard de la première électrode, ledit matériau à changement d'état étant disposé au moins partiellement au contact de l'électrode primaire et configurée pour prendre alternativement un état fortement résistif dans lequel l'électrode additionnelle est isolée électriquement de l'électrode primaire et un état faiblement résistif dans lequel l'électrode additionnelle est en conduction électrique avec l'électrode primaire de sorte à faire varier la surface électriquement active de la deuxième électrode.

Avantageusement, l'électrode additionnelle comprend une couche de matériau conducteur électriquement disposée de sorte que le matériau à changement d'état soit placé au moins partiellement entre l'électrode primaire et la couche de matériau conducteur électriquement de l'électrode additionnelle. Cette disposition en sandwich est de préférence orientée suivant une direction en épaisseur du premier empilement. Le matériau à changement de phase peut ainsi être configuré pour placer l'électrode primaire et la couche de matériau électriquement conducteur en continuité électrique ou alternativement en discontinuité électrique, selon son état plus ou moins conducteur. Préférentiellement, la couche de matériau conducteur électriquement de l'électrode additionnelle est en contact avec la couche de matériau à changement d'état.

Avantageusement, l'électrode primaire et l'électrode additionnelle sont au moins partiellement superposées.

Avantageusement, l'électrode primaire et l'électrode additionnelle sont en contact par leurs surfaces superposées.

Avantageusement, l'électrode primaire et l'électrode additionnelle sont en conduction électrique par leurs surfaces en contact.

Avantageusement, la première électrode comprend une première couche de matériau conducteur électriquement et une deuxième couche de matériau conducteur électriquement connectées électriquement de sorte à enchâsser la zone de matériau diélectrique, la zone de matériau diélectrique enchâssant la deuxième électrode.

Avantageusement, l'électrode primaire et l'électrode additionnelle sont au moins partiellement dans un même plan.

Avantageusement, le matériau à changement d'état comprend une couche discontinue formant des parcelles placées dans une matrice de matériau diélectrique.

Avantageusement, l'électrode primaire est une couche discontinue configurée pour permettre un recouvrement au moins partiel avec la couche discontinue de matériau à changement d'état, préférentiellement placée dans une matrice de matériau diélectrique

Avantageusement, la couche de matériau conducteur électriquement de l'électrode additionnelle est une couche discontinue configurée pour permettre un recouvrement au moins partiel avec la couche discontinue de matériau à changement d'état, préférentiellement placée dans une matrice de matériau diélectrique.

Avantageusement, le dispositif à condensateur comprend des moyens de commande (encore appelés organe de commande) de l'état du matériau à changement d'état.

Avantageusement, le matériau à changement d'état est un matériau bistable, préférentiellement dans un état faiblement résistif et dans un état fortement résistif, en l'absence d'action des moyens de commande.

Avantageusement, les moyens de commande sont conformés pour appliquer une différence de potentiel entre l'électrode primaire et la couche de matériau conducteur électriquement de l'électrode additionnelle.

Avantageusement, les moyens de commande comprennent une source de chaleur configurée pour générer un échauffement du matériau à changement d'état.

Avantageusement, la source de chaleur comprend une source de lumière.

Avantageusement, la source de lumière est un signal laser pulsé.

Avantageusement, le condensateur comprend au moins deux empilements dans lequel une des électrodes choisie parmi la première ou la deuxième électrode d'un empilement n étant commune à une électrode choisie parmi la deuxième ou la première électrode d'un empilement n+1, ladite électrode commune étant formée pour une part d'une électrode primaire de l'empilement n+1 en un matériau conducteur électriquement et, pour une autre part, d'une électrode additionnelle comprenant un matériau à changement d'état, l'électrode primaire et l'électrode additionnelle étant en regard d'une première électrode de l'empilement n+1, ledit matériau à changement d'état étant disposé au moins partiellement au contact de l'électrode primaire et configuré pour prendre alternativement un état fortement résistif dans lequel l'électrode additionnelle est isolée électriquement de l'électrode primaire et un état faiblement résistif dans lequel l'électrode additionnelle est en conduction électrique avec l'électrode primaire de sorte à faire varier la surface électriquement active de ladite électrode commune.

Avantageusement, la première électrode d'un empilement n comprend une première couche de matériau conducteur électriquement et une deuxième couche de matériau conducteur électriquement connectées électriquement de sorte à enchâsser la deuxième électrode de l'empilement n et la zone de matériau diélectrique et dans lequel l'électrode primaire de la deuxième électrode de l'empilement n+1 est formée par la deuxième couche de matériau conducteur électriquement de la première électrode de l'empilement n.

Avantageusement, la première électrode de l'empilement n+ 1 est connectée électriquement à la l'électrode primaire de l'empilement n de sorte à enchâsser la deuxième électrode de l'empilement n+1.

Suivant un autre aspect l'invention concerne, un procédé de variation de la capacité d'un condensateur à capacité variable tel que décrit ci-dessus caractérisé en ce qu'il comprend l'application d'un signal de commande de changement d'état du matériau à changement d'état de sorte à le faire passer d'un état fortement résistif dans lequel l'électrode additionnelle est isolée électriquement de l'électrode primaire et un état faiblement résistif dans lequel l'électrode additionnelle est en conduction électrique avec l'électrode primaire de sorte à faire varier la surface électriquement active de la deuxième électrode et de fait la capacité du condensateur.

Avantageusement, l'application d'un signal de commande est d'une durée limitée au changement d'état du matériau à changement d'état, lorsque le matériau à changement d'état est bistable.

Avantageusement, le signal de commande est une différence de potentiel appliqué entre la couche de matériau conducteur électriquement de l'électrode primaire et la couche de matériau conducteur électriquement de l'électrode additionnelle.

Avantageusement, le signal de commande est un échauffement du matériau à changement d'état généré par une source de chaleur.

Avantageusement, la source de chaleur est une source de lumière.

Avantageusement, la source de lumière est un signal laser pulsé.

Il est précisé que dans le cadre de la présente invention, le terme « sur », « surmonte » ou « sous-jacent » ou leurs équivalents ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Il est établi que la capacité électrique d'un condensateur se détermine essentiellement en fonction de la géométrie des électrodes et de la nature du ou des isolants ; la formule simplifiée suivante est souvent utilisée pour estimer sa valeur :

$$C = \varepsilon \frac{S}{e} \quad \text{Formule I}$$

avec S : surface des électrodes en regard, e distance entre les électrodes et $\varepsilon$ la permittivité du diélectrique.

On entend par surface électriquement active de la deuxième électrode, la surface de la deuxième électrode 5 en regard de la première électrode 2 et qui est dans un état conducteur électriquement.

Le condensateur selon l'invention est formé sur un substrat 20, par exemple en silicium passivé.

Le condensateur selon l'invention comprend un premier empilement comprenant une première électrode 2 et une deuxième électrode 5 en regard l'une de l'autre et espacée par une zone de matériau diélectrique 10.

De manière plus générale, le condensateur comprend une première armature et une deuxième armature. Les parties de la première armature et de la deuxième armature en regard constituent respectivement la première électrode 2 et la deuxième électrode 5.

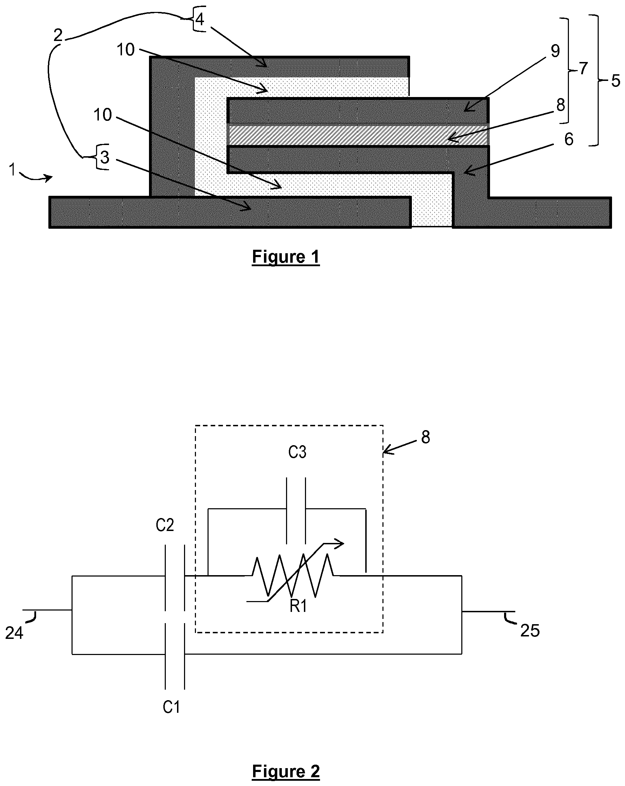

La zone de matériau diélectrique 10 espace la première électrode 2 et la deuxième électrode 5. On entend par zone une ou plusieurs couches de matériau diélectrique reliées entre elles. La zone 10 comprend préférentiellement, au moins une couche d'au moins un matériau diélectrique et telle qu'illustrée aux figures 1 et 3 à 7 au moins deux couches reliées. A titre d'exemple, le au moins un matériau diélectrique est choisi parmi SiO2 ou SiN. Préférentiellement, le matériau diélectrique est déposé par PECVD (en anglais Plasma-Enhanced Chemical Vapor Déposition). Le matériau diélectrique est préférentiellement le même dans toute la zone 10.

La première électrode 2 est en matériau conducteur électriquement. Préférentiellement, la première électrode comprend au moins une première couche de matériau conducteur électriquement 3.

Selon l'invention, la deuxième électrode 5 comprend une électrode primaire 6 et une électrode additionnelle 7. L'électrode primaire 6 comprend une couche de matériau électriquement conducteur et préférentiellement l'électrode primaire 6 est en matériau électriquement conducteur L'électrode additionnelle 7 comprend un matériau à changement d'état 8. L'électrode primaire 6 et l'électrode additionnelle 7 sont en regard de la première électrode 2.

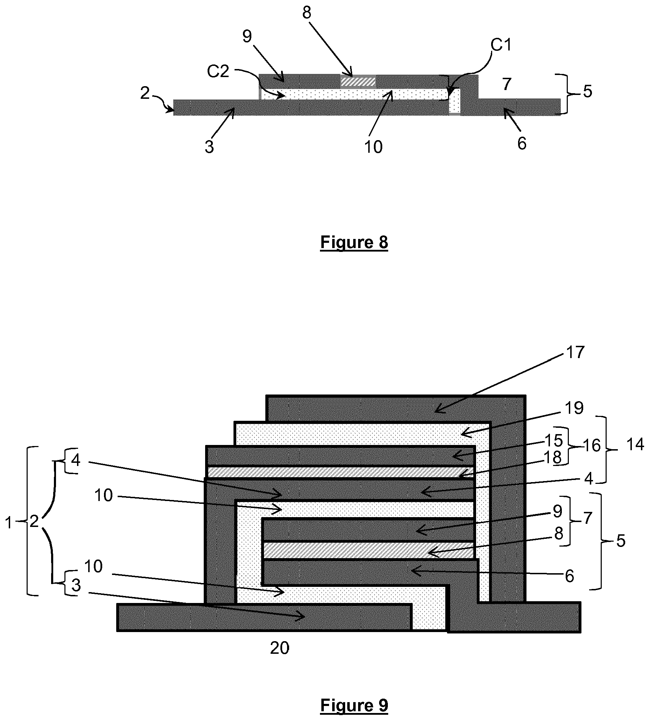

L'électrode primaire 6 et l'électrode additionnelle 7 sont au moins partiellement en contact l'une de l'autre. Selon un exemple illustré sur les figures 1 à 7, l'électrode primaire 6 et l'électrode additionnelle 7 sont superposées au moins partiellement. Selon un autre exemple illustré en figure 8, l'électrode primaire 6 et l'électrode additionnelle 7 sont sur un même niveau d'empilement, préférentiellement en contact dans le plan.

Le matériau à changement d'état 8 est un matériau dans lequel une transition résistive peut être observée. Le matériau à changement d'état 8 est configuré pour prendre alternativement un état fortement résistif et un état faiblement résistif. Le matériau à changement d'état 8 est dit dans un état fortement résistif, lorsque sa résistance est typiquement de l'ordre de 1 M$\Omega$. Le matériau à changement d'état 8 est dit dans un état faiblement résistif lorsque que sa résistance est typiquement de l'ordre de 1 $\Omega$. Le ratio défini entre la résistance du matériau à changement d'état dans un état fortement résistif et sa résistance dans un état faiblement résistif est compris entre 10, préférentiellement 100, et 1 000 000 Un ratio de 10, préférentiellement 100, est défini entre la résistance du matériau à changement d'état dans un état fortement résistif et sa résistance dans un état faiblement résistif. Ce matériau est de préférence de dilatation thermique nulle ou négligeable. Sa variation de volume, lors de l'utilisation du condensateur, peut être inférieure à 3% voire 1%.

La capacité totale du condensateur Ctot est mesurée entre les deux bornes 24, 25 de la première électrode 2 et de l'électrode primaire 6 de la deuxième électrode 5.

Dans l'état fortement résistif, la résistance du matériau à changement d'état 8 est telle que celui-ci se comporte comme un isolant et ne conduit pas de courant électrique.

Dans l'état faiblement résistif, la résistance du matériau à changement d'état 8 est telle que celui-ci permet une conduction du courant électrique.

Cette différence d'état entraîne une variation de la surface électriquement active de la deuxième électrode 5 et de fait une variation dans la capacité du condensateur suivant la formule I donnée ci-avant. Dans un état fortement résistif, la surface électriquement active de la deuxième électrode 5 correspond à la surface de l'électrode primaire 6 en regard de la première électrode 2. Dans un état faiblement résistif, la surface électriquement active de la deuxième électrode 5 correspond à la somme de la surface de l'électrode primaire 6 en regard de la première électrode 2 et de la surface de l'électrode additionnelle 7 en regard de la première électrode 2.

Selon un mode de réalisation préféré illustré sur l'ensemble des figures, l'électrode additionnelle 7 comprend une couche de matériau conducteur électriquement 9 agencée de sorte que le matériau à changement d'état 8 se situe au moins partiellement entre l'électrode primaire 6 et la couche de matériau conducteur électriquement 9 de l'électrode additionnelle 7.

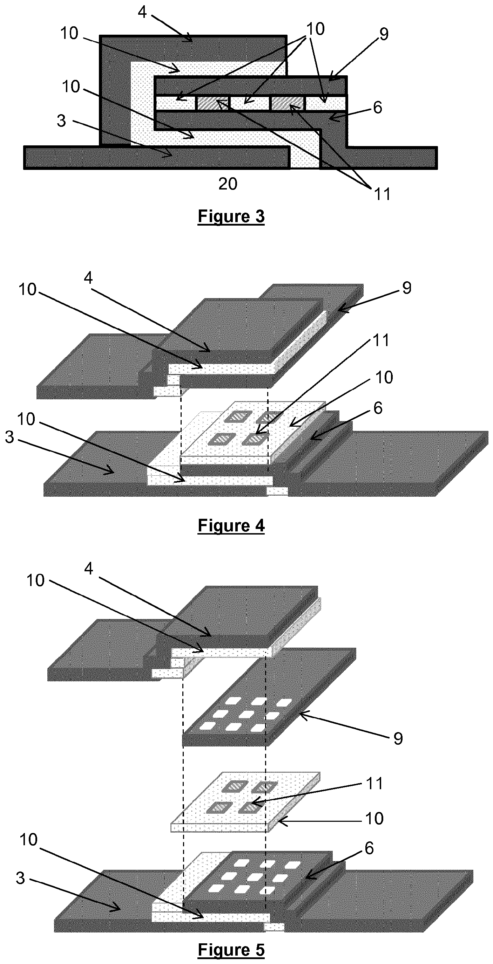

Suivant une première possibilité de ce mode de réalisation, la première électrode 2 comprend une première couche de matériau électriquement conducteur 3 et une deuxième couche de matériau électriquement conducteur 4 connectées électriquement. La première couche de matériau électriquement conducteur 3 étant au moins partiellement en regard de l'électrode primaire 6 espacées par au moins une portion de la zone de matériau diélectrique 10. La deuxième couche de matériau électriquement conducteur 4 étant au moins partiellement en regard de l'électrode additionnelle 7 espacées par au moins une portion de la zone de matériau diélectrique 10. La première électrode 2 enchâsse la deuxième électrode 5 et la zone de matériau diélectrique. La première électrode a une forme en U. Plus précisément, on peut obtenir l'empilement illustré en figure 1 et ses variantes illustrées aux figures 3 à 6.

Défini différemment, le condensateur selon l'invention comprend successivement au moins un empilement comprenant de bas en haut au moins :

- une première capacité comprenant :

  - une première couche de matériau conducteur formant une première électrode,
  - une première couche du matériau diélectrique,
  - une deuxième couche de matériau conducteur formant une deuxième électrode,

- une deuxième capacité comprenant :

  - une troisième couche de matériau conducteur formant une troisième électrode,
  - une deuxième couche du matériau diélectrique,
  - une quatrième couche de matériau conducteur formant une quatrième électrode.

Selon cette définition, l'empilement du condensateur comprend une couche de matériau à changement d'état disposée entre la deuxième électrode et la troisième électrode configurée pour prendre alternativement un état faiblement résistif dans lequel la deuxième électrode et la troisième électrode sont en continuité électrique et un état fortement résistif dans lequel la deuxième électrode et la troisième électrode sont isolées électriquement et que la première couche de matériau conducteur et la quatrième couche de matériau conducteur sont électriquement connectées.

Une première capacité C1 du condensateur est formée entre la première électrode 2 et l'électrode primaire 6 espacée par au moins une portion de la zone de matériau diélectrique 10.

Une deuxième capacité C2 du condensateur est formée entre la première électrode 2 et l'électrode additionnelle 7 espacée par au moins une portion de la zone de matériau diélectrique 10.

On entend par portion de la zone de matériau diélectrique 10 une partie de la zone formant une couche entre deux couches de matériau conducteur électriquement.

Lorsque le matériau à changement d'état 8 est dans un état faiblement résistif :

- la couche de matériau conducteur 9 de l'électrode additionnelle 7 est électriquement connectée à l'électrode primaire 6. Dans ce cas, la couche de matériau conducteur 9 de l'électrode additionnelle 7 et l'électrode primaire 6 forment une électrode commune, la deuxième électrode 5. Comme la première couche de matériau conducteur 3 et la deuxième couche de matériau conducteur 4 forment aussi une électrode commune par construction, la première électrode 2, alors la deuxième capacité C2 se retrouve placée électriquement en parallèle sur C1 entre les deux bornes 24, 25 du condensateur. La capacité totale Ctot du condensateur est donc la résultante des capacités C1 et C2 placées en parallèle ;
- la couche de matériau conducteur 9 est en continuité électrique avec l'électrode primaire 6. La surface électriquement active de la deuxième électrode 5 comprend la surface de l'électrode primaire 6 en regard de la première électrode 2, plus précisément en regard de la première couche de matériau conducteur 3 et la surface de l'électrode additionnelle 7, c'est-à-dire la couche de matériau conducteur 9 si elle est présente ou à défaut la surface du matériau à changement d'état 8, en regard de la première électrode 2, plus précisément de la deuxième couche de matériau conducteur électriquement 4 ;
- et comme le modèle électrique du matériau à changement d'état 8 peut être considéré comme une résistance R1, dont la valeur dépend de l'état dudit matériau à changement d'état 8, en parallèle avec une capacité C3, dont la valeur dépend principalement de la largeur de l'électrode primaire 6, de l'épaisseur du matériau à changement d'état 8 et de l'épaisseur de la couche de matériau conducteur 9 de l'électrode additionnelle 7 et tel le schéma illustré en figure 2. Suivant ce schéma, lorsque le matériau à changement d'état est dans un état faiblement résistif, la couche de matériau conducteur 9 de l'électrode additionnelle 7 est électriquement connectée à l'électrode primaire 6 par la résistance R1 et peuvent être considérées comme une électrode commune, la deuxième électrode 5. Comme la première couche de matériau conducteur 3 et la deuxième couche de matériau conducteur 4 forment aussi une électrode commune par construction, la première électrode 2 alors la deuxième capacité C2 se retrouve placée électriquement en parallèle sur C1 entre les deux bornes 24, 25 du condensateur. La capacité totale Ctot du dispositif est donc la résultante des capacités C1 et C2 placées en parallèle, C3 étant négligeable.

A contrario, lorsque le matériau à changement d'état 8 est dans un état fortement résistif :

- la couche de matériau conducteur 9 de l'électrode additionnelle 7 est électriquement isolée de l'électrode primaire 6 par la forte résistance du matériau à changement d'état 8. Dans ce cas la capacité totale Ctot du dispositif est uniquement égale à C1 ;
- seule l'électrode primaire 6 constitue une surface électriquement active de la deuxième électrode 5 ;
- et comme le modèle électrique du matériau à changement d'état 8 peut être considéré comme une résistance R1, dont la valeur dépend de l'état dudit matériau à changement d'état 8, en parallèle avec une capacité C3, dont la valeur dépend principalement de la largeur de l'électrode primaire 6, de l'épaisseur du matériau à changement d'état 8 et de l'épaisseur de la couche de matériau conducteur 9 de l'électrode additionnelle 7 et tel le schéma illustré en figure 2. Suivant ce schéma, lorsque le matériau à changement d'état 8 est dans un état fortement résistif, la couche de matériau électriquement conducteur 9 de l'électrode additionnelle 7 est électriquement isolée de l'électrode primaire 6 par la forte résistance du matériau à changement d'état 8 et électriquement connectée à l'électrode primaire 6 par une capacité C3. Dans ce cas on peut considérer que la capacité totale Ctot du condensateur est la résultante de la capacité C1 placée en parallèle des deux capacités séries C2 et C3.

Les couches de matériaux conducteurs électriquement 3, 4, 6, 9, sont par exemple des métaux comme du Nickel (Ni), de l'Argent (Ag), de l'Aluminium (Al), du cuivre (Cu), de l'or (Au) ou du Tungstène (W) déposé par exemple par une méthode PVD (Physical vapor Déposition). Outre les métaux, ces matériaux peuvent être tout type de conducteurs électriques comme par exemple des semiconducteurs (Silicium dopé par exemple), des oxydes métalliques (exemple : oxyde de ruthénium RuO2, Oxyde d'iridium IrO2) des films conducteurs transparents (exemple : oxyde conducteur comme l'ITO, polymère conducteur comme le PEDOT).

Les motifs géométriques des couches de matériaux conducteurs électriquement sont ensuite formés par exemple par des étapes de photo litho gravure.

Préférentiellement des couches intermédiaires de TiN par exemple peuvent être déposées entre les couches de matériaux conducteurs, le matériau diélectrique et le matériau à changement d'état pour former des couches de passivation ou des couches d'accroches. Ces couches ne sont ni détaillées, ni représentées sur les figures car elles ne sont pas fonctionnelles dans le cadre de la présente invention.

Le condensateur selon l'invention comprend des moyens de commande de l'état du matériau à changement d'état 8.

Préférentiellement selon l'invention, les matériaux à changement d'état 8 sont de type matériaux à changement de phase et utilisent préférentiellement un échauffement par effet joule pour changer d'état.

Selon une possibilité, cet échauffement par effet joule est effectué de préférence en appliquant une différence de potentiel pour générer un pulse de courant dans le matériau à changement d'état 8.

Avantageusement, la transition résistive du matériau à changement d'état 8 est contrôlée par la couche de matériau conducteur électriquement 9 de l'électrode additionnelle 7.

Les moyens de commandes comprennent selon une possibilité une ligne de commande connectée à la couche de matériau conducteur électriquement 9 destinée à appliquer une tension de polarisation entre la ligne de commande et la borne 24 de l'électrode primaire 6. Les tensions de polarisation nécessaires pour obtenir le changement d'état du matériau à changement d'état 8 sont de l'ordre de quelques volts (1 à 10V) et la puissance demandée de l'ordre de la dizaine de mW

Cette disposition permet d'amener le signal de commande du changement d'état par une ligne de commande indépendante des bornes 24, 25 d'entrée et de sortie, ce qui autorise le découplement du signal de commande du signal à transmettre.

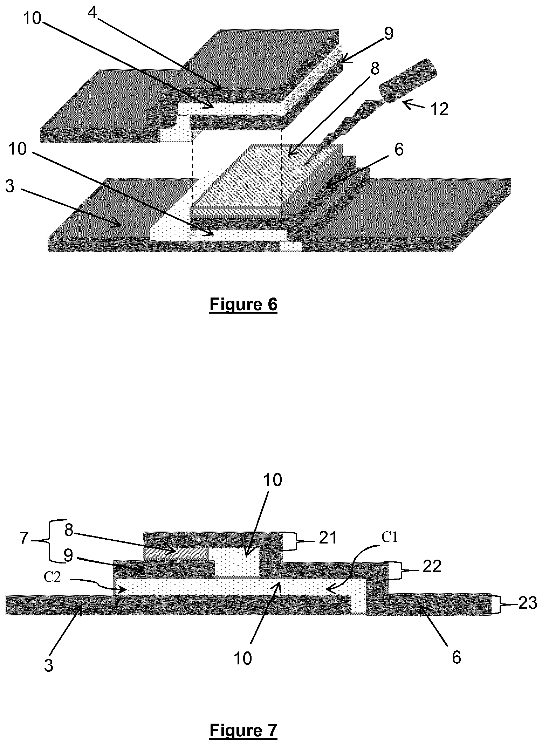

Selon une autre possibilité, toute source de chauffage permettant un échauffement intense et bref du matériau à changement d'état 8 peut être utilisé. On pourra par exemple commander le changement d'état grâce à une impulsion laser tel qu'illustré en figure 6. Les moyens de commande comprennent une source de chaleur, par exemple une source de lumière notamment de lumière pulsée type laser. Suivant cette possibilité, la couche de matériau conducteur 9 de l'électrode additionnelle 7 peut être conservée comme une simple électrode flottante ou peut être supprimée.

Selon un mode de réalisation illustré en figures 3 à 5, le matériau à changement d'état 8 peut être remplacé par au moins une parcelle 11 de ce matériau à changement d'état placée dans une matrice de matériau diélectrique 10. Les dimensions géométriques de cette parcelle sont suffisamment petites pour permettre une transition résistive plus efficace, c'est-à-dire avec un contraste de résistance plus élevé. Le changement d'état nécessite également moins d'énergie.

Préférentiellement, l'empilement 1 du condensateur comprend un réseau de parcelles 11, illustré aux figures 3 à 5. Cette mise en réseau permet de diminuer la résistance totale entre l'électrode primaire 6 et la couche de matériau conducteur 9 de l'électrode additionnelle 7 lorsque le matériau à changement d'état 8 est dans un état faiblement résistif.

Les parcelles 11 peuvent prendre différentes formes géométriques que ce soit des lignes ou des plots.

Les parcelles 11 peuvent être commandées par des moyens de commande communs ou indépendants.

Dans le cas tel que sur les figures 3 et 4, la ligne de commande de la couche de matériau conducteur 9 de l'électrode additionnelle 7 peut être remplacée par un réseau de lignes de commandes, chaque ligne commandant la transition résistive d'une parcelle 11 de matériau à changement d'état 8. Il est alors possible de contrôler indépendamment chaque parcelle 11 pour être certain d'avoir une transition résistive complète sur l'ensemble des parcelles 11. Ce contrôle individuel permet également de pouvoir faire commuter séparément chaque parcelle 11 afin de pouvoir obtenir plusieurs valeurs de résistance. Le matériau à changement d'état 8 devient ainsi une couche résistive ajustable pouvant prendre plusieurs valeurs de résistances.

La couche de matériau conducteur 9 de l'électrode additionnelle 7 s'apparente à une électrode de commande de l'état du matériau à changement de d'état 8. Dans le mode de réalisation où le matériau à changement d'état 8 est sous forme de parcelles 11, la couche de matériau conducteur 9 de l'électrode additionnelle 7 est préférentiellement sous forme d'une grille. Cette grille est préférentiellement complémentaire du réseau de parcelles 11 du matériau à changement d'état 8.. La forme de la grille est préférentiellement configurée pour permettre un recouvrement au moins partiel avec les parcelles 11. Il y a un contact entre les parcelles 11 et la grille.

Cette forme de grille telle qu'en figure 5 permet de concentrer les lignes de champ électrique et/ou le passage du courant dans les parcelles. L'électrode primaire 6 peut être optimisée de la même façon.

Selon un deuxième mode de réalisation de l'invention, le condensateur est défini dans un plan afin de réaliser un condensateur ajustable en utilisant moins de niveaux technologiques. Un exemple de ce mode de réalisation est illustré à la figure 7.

Le condensateur comprend une première électrode 2 comprenant une couche de matériau conducteur 3 planaire et une deuxième électrode 5 comprenant une électrode primaire 6 en matériau conducteur et une électrode additionnelle 7 comprenant un matériau à changement d'état 8 et une couche de matériau conducteur électrique 9. Le matériau à changement d'état 8 est placé entre l'électrode primaire 6 et la couche de matériau conducteur électriquement 9. Une zone de matériau diélectrique 10 sépare la première électrode 2 de la deuxième électrode 5. La couche de matériau conducteur électriquement 9 est disposée en regard de la première électrode 2, plus précisément en regard de la couche de matériau conducteur électriquement 3.

De cette manière, l'empilement 1 du condensateur comprend au moins un niveau de matériau conducteur de moins que le mode de réalisation illustré aux figures précédentes 1 à 6.

L'empilement comprend de bas en haut sur un substrat 20 une couche de matériau conducteur 3 formant la première électrode 2, puis une zone de matériau diélectrique 10, puis une couche de matériau conducteur électriquement 9 formant une partie de l'électrode additionnelle 7, puis un matériau à changement d'état 8, puis une couche de matériau conducteur électriquement formant l'électrode primaire 6. Cette électrode primaire 6 forme plusieurs niveaux de matériau conducteur de haut en bas, plus précisément sur trois niveaux : au-dessus et en contact du matériau à changement d'état 8, niveau 21, puis sur le même niveau 22 que la couche de matériau conducteur électriquement 9 mais séparé par une zone de matériau diélectrique 10, puis au niveau 23 de la couche de matériau conducteur 3 de la première électrode 2 mais séparé par une zone de matériau diélectrique 10.

Le niveau 22 de l'électrode primaire 6 en regard de la couche de matériau conducteur 3 de la première électrode 2 espacée par une zone de matériau diélectrique 10 forme une première capacité C1.

Une deuxième capacité C2 est formée par la couche de matériau conducteur électriquement 9 en regard de la couche de matériau conducteur 3 de la première électrode 2 espacée par une zone de matériau diélectrique 10.

Lorsque le matériau à changement d'état 8 est dans un état fortement résistif la capacité totale mesurée entre les bornes 24, 25 de la première électrode 2 et de la deuxième électrode 5 est proche de la valeur de la capacité C1 mesurée entre les parties de la première électrode 2 et la deuxième électrode 5 en vis-à-vis c'est-à-dire entre la première électrode 2 en vis-à-vis de l'électrode primaire 6.

Lorsque le matériau à changement d'état est dans un état faiblement résistif alors l'électrode primaire 6 peut être considérée comme électriquement connectée à la couche de matériau conducteur 9 de l'électrode additionnelle 7. L'électrode primaire 6 et la couche de matériau conducteur 9 de l'électrode additionnelle 7 forment ainsi la deuxième électrode 5. Dans ce cas la capacité totale mesurée entre les bornes 24, 25 de la première électrode 2 et de l'électrode primaire 6 est proche de la résultante des capacités C1 et C2 placées en parallèles, C2 étant la capacité formée par les parties en vis-à-vis de la première électrode 2 et du matériau à changement de d'état 8 ou de la couche de matériau conducteur 9 de l'électrode additionnelle 7 si présente.

L'invention concerne également un condensateur comprenant n empilements, étant compris entre 2 et 10, plus préférentiellement entre 2 et 5. Pour la suite de la description, on parle de premier et de deuxième empilement : un premier empilement 1 et un deuxième empilement 13. Préférentiellement, les empilements sont identiques.

Chaque empilement comprend avantageusement une première électrode, une deuxième électrode et une couche de matériau diélectrique. Une des deux électrodes comprend une couche de matériau à changement d'état.

Le condensateur comprend plusieurs niveaux de matériaux à changement d'état 8, 18. Sur la figure 9 est donné un exemple comprenant deux empilements 1 et 13, soit deux couches de matériaux à changement d'état 8,18. Avantageusement, le système comprend une électrode commune au premier empilement 1 et au deuxième empilement 13. Selon un mode de réalisation, l'électrode commune est la première électrode 2 du premier empilement 1 qui constitue alors l'électrode primaire du deuxième empilement 13.

Selon l'invention, le premier empilement 1 comprend, tel que décrit ci-avant, une première électrode 2 et une deuxième électrode 5 en regard de la première électrode 2 et une zone d'un matériau diélectrique 10 disposée entre lesdites première et deuxième électrodes, la deuxième électrode 5 est formée pour une part d'une électrode primaire 6 en un matériau électriquement conducteur et, pour une autre part, d'une électrode additionnelle 7 comprenant un matériau à changement d'état 8, l'électrode primaire 6 et l'électrode additionnelle 7 étant en regard de la première électrode 2, ledit matériau à changement d'état 8 étant disposé au moins partiellement au contact de l'électrode primaire 6 et configurée pour prendre alternativement un état fortement résistif dans lequel l'électrode additionnelle est isolée électriquement de l'électrode primaire et un état faiblement résistif dans lequel l'électrode additionnelle est en conduction électrique avec l'électrode primaire 6 de sorte à faire varier la surface électriquement active de la deuxième électrode 5.

Le deuxième empilement 13 comprend une deuxième électrode 14 et une première électrode 17 en regard de la deuxième électrode 14 et une zone d'un matériau diélectrique 10 disposée entre lesdites deuxième et première électrodes, la deuxième électrode 14 est formée pour une part d'une électrode primaire en un matériau électriquement conducteur et, pour une autre part, d'une électrode additionnelle 16 comprenant un matériau à changement d'état 18. L'électrode primaire et l'électrode additionnelle 16 étant en regard de la première électrode 17, ledit matériau à changement d'état 18 étant disposé au moins partiellement au contact de l'électrode primaire et configuré pour prendre alternativement un état fortement résistif dans lequel l'électrode additionnelle 16 est isolée électriquement de l'électrode primaire et un état faiblement résistif dans lequel l'électrode additionnelle 16 est en conduction électrique avec l'électrode primaire de sorte à faire varier la surface électriquement active de la deuxième électrode 14. Préférentiellement, l'électrode primaire du deuxième empilement 13 est la première électrode 2 du premier empilement 1 et plus précisément la couche de matériau conducteur 4.

La première électrode 17 du deuxième empilement 13 est reliée électriquement à la deuxième électrode 5 du premier empilement 1.

Selon l'invention, l'électrode additionnelle 16 de la deuxième électrode 14 comprend le matériau à changement d'état 18 et une couche de matériau conducteur électriquement 15.

Préférentiellement, les transitions résistives de ces deux couches de matériaux à changement d'état 8,18 sont commandées par deux lignes de commandes distinctes formées par des couches de matériaux conducteurs électriquement 9, 15.

Avec un condensateur avec deux empilements tels que décrits ci-dessus, quatre valeurs de capacité différentes peuvent être obtenues :

- <u>Valeur 1</u> : les deux matériaux à changement d'état 8, 18 sont dans un état hautement résistif.

Dans le premier empilement :

- la deuxième électrode 5 du premier empilement 1 est formée par la première électrode primaire 6 uniquement, en regard de la première couche de matériau conducteur 3 de la première électrode 2 ;
- la couche de matériau conducteur 9 de l'électrode additionnelle 7 est électriquement isolée de l'électrode primaire 6 par la forte résistance du matériau à changement d'état 8.

Dans le deuxième empilement 13 :

- la couche de matériau conducteur 15 de l'électrode additionnelle 16 est électriquement isolée de l'électrode primaire 4 par la forte résistance du matériau à changement d'état 18.

Dans ce cas la capacité totale Ctot du dispositif est uniquement égale à C1 formée entre l'électrode primaire 6 du premier empilement et la couche de matériau conducteur 3 du premier empilement 1.

- <u>Valeur 2</u> : la première couche de matériau à changement d'état 8 est dans un état faiblement résistif et la deuxième couche 18 dans un état fortement résistif.

Dans le premier empilement :

- la deuxième électrode 5 du premier empilement est formée par l'électrode primaire 6 en regard de la première couche de matériau conducteur 3 de la première électrode 2 et de la couche de matériau conducteur électriquement 9 de l'électrode additionnelle 7 en regard de la deuxième couche de matériau conducteur 4 de la première électrode 2.

Dans le deuxième empilement 13 :

- la couche de matériau conducteur 15 de l'électrode additionnelle 16 est électriquement isolée de l'électrode primaire 4 du deuxième empilement par la forte résistance du matériau à changement d'état 18.

Dans ce cas la capacité totale Ctot du dispositif est égale à la résultante des capacités C1 et C2 placées en parallèle, C1 étant formée entre l'électrode primaire 6 du premier empilement et la couche de matériau conducteur 3 du premier empilement 1 et C2 entre la couche de matériau conducteur 4 de la première électrode 2 du premier empilement 1 et la couche de matériau conducteur 9 de l'électrode additionnelle 7 du premier empilement.

• Valeur 3 : la première couche de matériau à changement d'état 8 est dans un état fortement résistif et la deuxième couche 18 dans un état faiblement résistif.

Dans le premier empilement :

- la deuxième électrode 5 est formée par l'électrode primaire 6 uniquement, en regard de la première couche de matériau conducteur 3 de la première électrode 2 ;
- la couche de matériau conducteur 9 de l'électrode additionnelle 7 est électriquement isolée de l'électrode primaire 6 par la forte résistance du matériau à changement d'état 8.

Dans le deuxième empilement 13:

- la deuxième électrode 14 est formée par l'électrode primaire 4 électriquement connectée à la couche de matériau conducteur 3 de la première électrode 2 du premier empilement 1 et par la couche de matériau conducteur électriquement 15 de l'électrode additionnelle 16 du deuxième empilement 13 en regard de la couche de matériau conducteur de la première électrode 17 électriquement connectée à l'électrode primaire 6 du premier empilement 1.

De cette manière, la capacité totale Ctot du condensateur est égale à la résultante des capacités C1 et C4 placées en parallèle, C1 étant formée entre l'électrode primaire 6 du premier empilement 1 et la couche de matériau conducteur 3 du premier empilement 1 et C4 entre la première électrode 17 et la couche de matériau conducteur 15 du deuxième empilement 13.

• Valeur 4 : les deux couches de matériaux à changement d'état 8,18 sont dans un état faiblement résistif.

Dans le premier empilement :

- la deuxième électrode 5 du premier empilement 1 est formée par l'électrode primaire 6 en regard de la première couche de matériau conducteur 3 de la première électrode 2 et par la couche de matériau conducteur électriquement 9 de l'électrode additionnelle 7 en regard de la deuxième couche de matériau conducteur 4 de la première électrode 2.

Dans le deuxième empilement 13 :

- la deuxième électrode 14 est formée par la couche de matériau conducteur de l'électrode primaire 4 électriquement connectée à la couche de matériau conducteur 3 de la première électrode 2 et par la couche de matériau conducteur électriquement 15 de l'électrode additionnelle 16 en regard de la couche de matériau conducteur de la première électrode 17 électriquement connectée à l'électrode primaire 6 du premier empilement 1.

De cette manière la capacité totale Ctot du condensateur est égale à la résultante des capacités C1, C2 et C4 placées en parallèle, C1 étant formée entre l'électrode primaire 6 du premier empilement 1 et la couche de matériau conducteur 3 du premier empilement 1, C2 entre la couche de matériau conducteur 4 de la première électrode 2 du premier empilement 1 et la couche de matériau conducteur 9 du premier empilement 1 et C4 entre la couche de matériau conducteur de de la première électrode 17 et la couche de matériau conducteur 15 du deuxième empilement 13.

Selon une possibilité de l'invention, le matériau à changement d'état 8,18 est un matériau à changement de phase tel du Ge2Sb2Te5 ou du GeTe dans lequel un contraste de résistance de $10^6$ peut être obtenu suite à un échauffement par effet joule. Cette modification est due au changement rapide et réversible entre une phase amorphe hautement résistive et une phase cristalline peu résistive.

Selon une possibilité, le matériau à changement d'état 8,18 est un isolant comme un verre de chalcogénures, par exemple GeTe, GeSe, GeS, AsS ou un isolant comme un oxyde tel SiO2 ou WO3. Préférentiellement, selon cette possibilité l'électrode primaire 6 est en Nickel ou en Aluminium et l'électrode additionnelle 7 comprend une couche de matériau conducteur électriquement 9 en argent ou en cuivre. Avantageusement, selon cette possibilité, le matériau à changement d'état 8,18 est dopé par un élément métallique mobile comme de l'Argent ou du Cuivre. L'application d'une impulsion électrique polarisée entre l'électrode primaire 6 et la couche de matériau conducteur électriquement 9 de l'électrode additionnelle 7 permet de former un pont conducteur entre l'électrode primaire 6 et la couche de matériau conducteur électriquement 9 de l'électrode additionnelle 7, ou inversement de rompre ce pont conducteur en inversant la polarisation, par des mécanismes de déplacement d'ions ou d'oxydoréduction.

Selon une autre possibilité, le matériau à changement d'état 8, 18 est un oxyde actif tel qu'un oxyde à transition métallique de type NiO, TiO, CuO, ZrO, HfO. La transition résistive est obtenue par création d'un pont conducteur dans l'oxyde lors de l'application d'un champ électrique entre l'électrode primaire 6 et la couche de matériau conducteur électriquement 9 de l'électrode additionnelle 7ou rupture de ce pont lors de l'inversion de la polarisation.

Le matériau à changement d'état 8, 18 peut être déposé par des méthodes PVD ou CVD (Chemical Vapor Déposition), et les motifs sont ensuite formés par des étapes de photo litho gravure.

Dans le mode de réalisation comprenant plusieurs couches de matériaux à changement d'état 8, 18, comme dans le système de condensateurs selon l'invention, les couches de matériaux à changement d'état 8, 18 peuvent être identiques ou bien différentes.

L'invention concerne également un procédé de variation de la capacité d'un condensateur tel que décrit ci-dessus. Le procédé comprend l'application d'un signal de commande de l'état du matériau à changement d'état 8 de sorte à le faire passer d'un état fortement résistif dans lequel l'électrode additionnelle 7 est isolée électriquement de l'électrode primaire 6 et un état faiblement résistif dans lequel l'électrode additionnelle 7 est en conduction électrique avec l'électrode primaire 6 de sorte à faire varier la surface électriquement active de la deuxième électrode 5 et de fait la capacité du condensateur.

Un exemple détaillé des étapes de fabrication d'un condensateur selon l'invention est donné ci-après. Sur un substrat 20 support, par exemple un substrat de silicium passivé par une couche de SiO2 (dioxyde de silicium) une première électrode 2 est réalisée. Cette électrode 2 en matériau conducteur est par exemple réalisée avec du W (Tungstène) d'épaisseur 200nm déposé par PVD (Physical Vapor déposition) et le motif de l'électrode 2 est réalisé par photolithographie et gravure RIE (reactive ionic etching).

Un premier niveau de matériau diélectrique 10 est réalisé, par exemple par dépôt PECVD (Plasma Enhanced Chemical Vapor déposition) de 100nm de SiN puis photolithographie et gravure des motifs par RIE.

Dépôt d'un deuxième niveau de matériau conducteur électrique formant l'électrode primaire 6 constituée par exemple d'une couche de TiN d'épaisseur 50nm et d'une couche en W d'épaisseur 200nm déposés par PVD. Les motifs sont réalisés par photolithographie puis gravure RIE successive du W puis du TiN.

Le matériau à changement d'état 8, par exemple du GeTe d'épaisseur 100nm, est ensuite déposé entre deux couches de TiN de 5nm. L'ensemble de cet empilement est déposé par PVD puis les motifs sont formés par photolithographie et gravure IBE (Ion Beam Etching) de l'empilement.

Dépôt d'un troisième niveau de matériau conducteur électrique 9 formant partiellement l'électrode additionnelle 7 constituée par exemple d'une couche de TiN d'épaisseur 15nm et d'une couche en W d'épaisseur 200nm déposés par PVD. Les motifs sont réalisés par photolithographie puis gravure RIE successive du W puis du TiN.

Un deuxième niveau de matériau diélectrique 10 est réalisé, par exemple par un dépôt PECVD de 100nm de SiN puis photolithographie et gravure des motifs par RIE.

Finalement la dernière couche de matériau conducteur électriquement formant partiellement la première électrode 2 est réalisée. Cette électrode en matériau conducteur 4 est par exemple composée d'un empilement de TiN d'épaisseur 50 nm et de W d'épaisseur 200nm déposés par PVD et le motif de l'électrode est réalisé par une étape de photolithographie et la gravure RIE successive du W et du TiN.

REFERENCES

1. Premier empilement
2. Première électrode
3. Première couche de matériau conducteur électriquement
4. Deuxième couche de matériau conducteur électriquement / Electrode primaire
5. Deuxième électrode
6. Electrode primaire
7. Electrode additionnelle
8. Matériau à changement d'état
9. Couche de matériau conducteur électriquement
10. Zone de matériau diélectrique
11. Parcelle de matériau à changement d'état
12. Commande laser
13. Deuxième empilement
14. Deuxième électrode
15. Couche de matériau conducteur électriquement
16. Electrode additionnelle
17. Première électrode
18. Matériau à changement d'état
19. Zone de matériau diélectrique
20. Substrat
21. Niveau
22. Niveau
23. Niveau
24. Borne
25. Borne
C1. Première capacité
C2. Deuxième capacité
C3. Troisième capacité

R1. Résistance de la troisième capacité
C4. Quatrième capacité
C5. Cinquième capacité
R2. Résistance de la cinquième capacité

**Revendications**

1. Condensateur électrique à capacité variable comprenant au moins un premier empilement comportant une première électrode (2) et une deuxième électrode (5) en regard de la première électrode (2) et une zone d'un matériau diélectrique (10) disposée entre lesdites première et deuxième électrodes (2, 5), la deuxième électrode (5) comprenant pour une part une électrode primaire (6) en un matériau électriquement conducteur et, pour une autre part, une électrode additionnelle (7) comprenant un matériau à changement d'état (8), l'électrode primaire (6) et l'électrode additionnelle (7) étant configurées pour être respectivement en regard de la première électrode (2) suivant une orientation invariable, durant le fonctionnement du condensateur, relativement à la première électrode (2), ledit matériau à changement d'état (8) étant disposé au moins partiellement au contact de l'électrode primaire (6) et configurée pour prendre alternativement un état fortement résistif dans lequel l'électrode additionnelle (7) est isolée électriquement de l'électrode primaire (6) et un état faiblement résistif dans lequel l'électrode additionnelle (7) est en conduction électrique avec l'électrode primaire (6) de sorte à faire varier la surface électriquement active de la deuxième électrode (5) sans variation d'orientation de l'électrode primaire (6) et de l'électrode additionnelle (7) par rapport à la première électrode (2).

2. Condensateur selon la revendication précédente dans lequel l'électrode additionnelle (7) comprend une couche de matériau conducteur électriquement (9) disposée de sorte que le matériau à changement d'état (8) soit placé au moins partiellement entre l'électrode primaire (6) et la couche de matériau conducteur électriquement (9) de l'électrode additionnelle (7) suivant une direction en épaisseur du premier empilement.

3. Condensateur selon l'une quelconque des revendications précédentes dans lequel l'électrode primaire (6) et l'électrode additionnelle (7) présentent des surfaces superposées au contact l'une de l'autre.

4. Condensateur selon l'une quelconque des revendications précédentes dans lequel la première électrode (2) comprend une première couche de matériau conducteur électriquement (3) et une deuxième couche de matériau conducteur électriquement (4) connectées électriquement de sorte à enchâsser la zone de matériau diélectrique (10), elle-même enchâssant la deuxième électrode (5).

5. Condensateur selon l'une quelconque des revendications 1 à 3 dans lequel l'électrode primaire (6) et l'électrode additionnelle (7) sont au moins partiellement dans un même plan.

6. Condensateur selon l'une quelconque des revendications précédentes dans lequel le matériau à changement d'état (8) comprend une couche discontinue formant des parcelles (11) placées dans une matrice de matériau diélectrique.

7. Condensateur selon la revendication précédente dans lequel l'électrode primaire (6) est une couche discontinue configurée pour permettre un recouvrement au moins partiel avec la couche discontinue de matériau à changement d'état (8).

8. Condensateur selon l'une quelconque des deux revendications précédentes en combinaison avec la revendication 2 dans lequel la couche de matériau conducteur électriquement (9) de l'électrode additionnelle (7) est une couche discontinue configurée pour permettre un recouvrement au moins partiel avec la couche discontinue de matériau à changement d'état (8).

9. Condensateur selon l'une quelconque des revendications précédentes dans lequel le matériau à changement d'état (8) est un matériau bistable.

10. Dispositif comprenant un condensateur selon l'une quelconque des revendications précédentes et des moyens de commande de l'état du matériau à changement d'état (8).

11. Dispositif selon la revendication précédente lorsque celle-ci dépend de la revendication 6 comprenant des moyens de commande indépendants pour chaque parcelle (11).

12. Dispositif selon l'une quelconque des deux revendications précédentes lorsque celle-ci dépend de la revendication 2, dans lequel les moyens de commande sont conformés pour appliquer une différence de potentiel entre l'électrode primaire (6) et la couche de matériau conducteur électriquement (9) de l'électrode additionnelle (7).

13. Dispositif selon l'une quelconque des revendications 10 ou 11, dans lequel les moyens de commande comprennent une source de chaleur configurée pour générer un échauffement du matériau à changement d'état (8).

14. Dispositif selon la revendication précédente dans lequel la source de chaleur comprend une source de lumière.

15. Condensateur électrique à capacité variable, comprenant au moins :

- un premier empilement comportant une première électrode (2) et une deuxième électrode (5) en regard de la première électrode (2) et une zone d'un matériau diélectrique (10) disposée entre lesdites première et deuxième électrodes (2, 5), premier empilement dans lequel la deuxième électrode (5) comprend pour une part une électrode primaire (6) en un matériau électriquement conducteur et, pour une autre part une électrode additionnelle (7) comprenant un matériau à changement d'état (8), l'électrode primaire (6) et l'électrode additionnelle (7) étant respectivement configurées pour être en regard de la première électrode (2) suivant une orientation invariable, durant le fonctionnement du condensateur, relativement à la première électrode (2), ledit matériau à changement d'état (8) étant disposé au moins partiellement au contact de l'électrode primaire (6) et configurée pour prendre alternativement un état fortement résistif dans lequel l'électrode additionnelle (7) est isolée électriquement de l'électrode primaire (6) et un état faiblement résistif dans lequel l'électrode additionnelle (7) est en conduction électrique avec l'électrode primaire (6) de sorte à faire varier la surface électriquement active de la deuxième électrode (5) sans variation d'orientation de l'électrode primaire (6) et de l'électrode additionnelle (7) par rapport à la première électrode (2),
- un deuxième empilement comprenant une troisième électrode (17) et une quatrième électrode (14) en regard de la troisième électrode (17) et une zone d'un matériau diélectrique disposée entre lesdites troisième et quatrième électrodes, la quatrième électrode (14) est formée pour une part d'une électrode primaire en un matériau électriquement conducteur et, pour une autre part, d'une électrode additionnelle comprenant un matériau à changement d'état du deuxième empilement, l'électrode primaire et l'électrode additionnelle de la quatrième électrode (14) étant respectivement en regard de la troisième électrode (17), ledit matériau à changement d'état du deuxième empilement étant disposé au moins partiellement au contact de l'électrode primaire de la quatrième électrode (14) et étant configurée pour prendre alternativement un état fortement résistif dans lequel l'électrode additionnelle de la quatrième électrode (14) est isolée électriquement de l'électrode primaire de la quatrième électrode (14) et un état faiblement résistif dans lequel l'électrode additionnelle de la quatrième électrode (14) est en conduction électrique avec l'électrode primaire de la quatrième électrode (14) de sorte à faire varier la surface électriquement active de la quatrième électrode (17), sans variation d'orientation de l'électrode primaire de la quatrième électrode (14) et de l'électrode additionnelle de la quatrième électrode (14) par rapport à la troisième électrode (17),

et dans lequel la partie de la première électrode (2) du premier empilement qui est en regard de l'électrode additionnelle du premier empilement forme l'électrode primaire du deuxième empilement
et dans lequel la deuxième électrode (5) du premier empilement forme une partie de la troisième électrode qui est en regard de l'électrode primaire du deuxième empilement.

16. Condensateur selon la revendication précédente dans lequel la première électrode (2) du premier empilement comprend une première couche de matériau conducteur électriquement (3) et une deuxième couche de matériau conducteur électriquement (4) connectées électriquement de sorte à enchâsser la partie de la troisième électrode (5) du deuxième empilement qui est en regard de l'électrode primaire du deuxième empilement et une zone de matériau diélectrique (10) et dans lequel l'électrode primaire du deuxième empilement est formée par la deuxième couche de matériau conducteur électriquement (4) de la première électrode (2) du premier empilement.

17. Condensateur selon l'une quelconque des deux revendications précédentes, dans lequel une partie de la troisième électrode (17) qui est en regard de l'électrode additionnelle du deuxième l'empilement est connectée électriquement à l'électrode primaire (6) du premier empilement, de sorte à enchâsser la quatrième électrode (14) du deuxième empilement.

18. Procédé de variation de la capacité d'un condensateur à capacité variable selon l'une quelconque des revendications 1 à 9 **caractérisé en ce qu'**il comprend l'application d'un signal de commande de l'état du matériau à changement d'état (8) de sorte à le faire passer d'un état fortement résistif dans lequel l'électrode additionnelle (7) est isolée électriquement de l'électrode primaire (6) à un état faiblement résistif dans lequel l'électrode additionnelle (7) est en conduction électrique avec l'électrode primaire (6) de sorte à faire varier la surface électriquement active de la deuxième électrode (5) et de fait la capacité du condensateur.

**19.** Procédé selon la revendication précédente dans lequel l'application d'un signal de commande est d'une durée limitée au changement d'état du matériau à changement d'état (8), ce dernier étant bistable.

**20.** Procédé selon l'une quelconque des deux revendications précédentes lorsque celle-ci dépend de la revendication 2, et dans lequel le signal de commande est une différence de potentiel appliqué entre la couche de matériau conducteur électriquement de l'électrode primaire (6) et la couche de matériau conducteur électriquement (9) de l'électrode additionnelle (7).

**21.** Procédé selon l'une quelconque des revendications 18 ou 19 dans lequel le signal de commande est un échauffement du matériau à changement de d'état (8) généré par une source de chaleur.

**22.** Procédé selon la revendication précédente dans lequel la source de chaleur est une source de lumière.

**Patentansprüche**

**1.** Elektrischer Kondensator mit variabler Kapazität, umfassend mindestens einen ersten Stapel, umfassend eine erste Elektrode (2) und eine zweite Elektrode (5), gegenüberliegend der ersten Elektrode (2), und eine Zone aus einem dielektrischen Material (10), die zwischen der ersten und der zweiten Elektrode (2, 5) angeordnet ist,
wobei die zweite Elektrode (5) einerseits eine primäre Elektrode (6) aus einem elektrisch leitenden Material und andererseits eine zusätzliche Elektrode (7), umfassend ein Material mit Zustandsveränderung (8), umfasst, wobei die primäre Elektrode (6) und die zusätzliche Elektrode (7) dazu konfiguriert sind, während des Betriebs des Kondensators jeweils gegenüberliegend der ersten Elektrode (2) gemäß einer invariablen Ausrichtung in Bezug auf die erste Elektrode (2) zu sein, wobei das Material mit Zustandsveränderung (8) zumindest zum Teil in Kontakt mit der primären Elektrode (6) angeordnet ist und dazu konfiguriert ist, alternierend einen Zustand mit hohem Widerstand, wobei die zusätzliche Elektrode (7) von der primären Elektrode (6) elektrisch isoliert ist, und einen Zustand mit niedrigem Widerstand, wobei die zusätzliche Elektrode (7) in elektrischer Leitung mit der primären Elektrode (6) ist, anzunehmen, um die elektrisch aktive Oberfläche der zweiten Elektrode (5) ohne Variation der Ausrichtung der primären Elektrode (6) und der zusätzlichen Elektrode (7) bezüglich der ersten Elektrode (2) variieren zu lassen.

**2.** Kondensator nach dem vorhergehenden Anspruch, wobei die zusätzliche Elektrode (7) eine Schicht aus elektrisch leitendem Material (9) umfasst, die so angeordnet ist, dass das Material mit Zustandsveränderung (8) zumindest zum Teil zwischen der primären Elektrode (6) und der Schicht aus elektrisch leitendem Material (9) der zusätzlichen Elektrode (7) gemäß einer Richtung der Dicke des ersten Stapels platziert wird.

**3.** Kondensator nach einem der vorhergehenden Ansprüche, wobei die primäre Elektrode (6) und die zusätzliche Elektrode (7) Oberflächen aufweist, die in Kontakt miteinander überlagert sind.

**4.** Kondensator nach einem der vorhergehenden Ansprüche, wobei die erste Elektrode (2) eine erste Schicht aus elektrisch leitendem Material (3) und eine zweite Schicht aus elektrisch leitendem Material (4) umfasst, die so elektrisch verbunden sind, dass die Zone aus dielektrischem Material (10) eingefasst wird, die selbst die zweite Elektrode (5) einfasst.

**5.** Kondensator nach einem der Ansprüche 1 bis 3, wobei die primäre Elektrode (6) und die zusätzliche Elektrode (7) zumindest zum Teil in derselben Ebene sind.

**6.** Kondensator nach einem der vorhergehenden Ansprüche, wobei das Material mit Zustandsveränderung (8) eine unterbrochene Schicht umfasst, die Parzellen (11) bildet, die in einer Matrix aus dielektrischem Material platziert sind.

**7.** Kondensator nach dem vorhergehenden Anspruch, wobei die primäre Elektrode (6) eine unterbrochene Schicht ist, die dazu konfiguriert ist, eine zumindest teilweise Abdeckung mit der unterbrochenen Schicht aus Material mit Zustandsveränderung (8) zu ermöglichen.

**8.** Kondensator nach einem der zwei vorhergehenden Ansprüche in Kombination mit Anspruch 2, wobei die Schicht aus elektrisch leitendem Material (9) der zusätzlichen Elektrode (7) eine unterbrochene Schicht ist, die dazu konfiguriert ist, eine zumindest teilweise Abdeckung mit der unterbrochenen Schicht aus Material mit Zustandsveränderung (8) zu ermöglichen.

**9.** Kondensator nach einem der vorhergehenden Ansprüche, wobei das Material mit Zustandsveränderung (8) ein bistabiles Material ist.

**10.** Vorrichtung, umfassend einen Kondensator nach einem der vorhergehenden Ansprüche und Mittel zur Steuerung des Zustands des Materials mit Zustandsveränderung (8).

**11.** Vorrichtung nach dem vorhergehenden Anspruch bei Abhängigkeit von Anspruch 6, umfassend unabhängige Steuermittel für jede Parzelle (11).

**12.** Vorrichtung nach einem der zwei vorhergehenden Ansprüche bei Abhängigkeit von Anspruch 2, wobei die Steuermittel dazu angepasst sind, eine Potentialdifferenz zwischen der primären Elektrode (6) und der Schicht aus elektrisch leitendem Material (9) der zusätzlichen Elektrode (7) anzuwenden.

**13.** Vorrichtung nach einem der Ansprüche 10 oder 11, wobei die Steuermittel eine Wärmequelle umfassen, die dazu konfiguriert ist, eine Erhitzung des Materials mit Zustandsveränderung (8) zu erzeugen.

**14.** Vorrichtung nach dem vorhergehenden Anspruch, wobei die Wärmequelle eine Lichtquelle umfasst.

**15.** Elektrischer Kondensator mit variabler Kapazität, umfassend mindestens:

- einen ersten Stapel, umfassend eine erste Elektrode (2) und eine zweite Elektrode (5), gegenüberliegend der ersten Elektrode (2), und eine Zone aus einem dielektrischen Material (10), die zwischen der ersten und der zweiten Elektrode (2, 5) des ersten Stapels angeordnet ist, wobei die zweite Elektrode (5) einerseits eine primäre Elektrode (6) aus einem elektrisch leitenden Material und andererseits eine zusätzliche Elektrode (7), umfassend ein Material mit Zustandsveränderung (8), umfasst, wobei die primäre Elektrode (6) und die zusätzliche Elektrode (7) jeweils dazu konfiguriert sind, während des Betriebs des Kondensators gegenüberliegend der ersten Elektrode (2) gemäß einer invariablen Ausrichtung in Bezug auf die erste Elektrode (2) zu sein, wobei das Material mit Zustandsveränderung (8) zumindest zum Teil in Kontakt mit der primären Elektrode (6) angeordnet ist und dazu konfiguriert ist, alternierend einen Zustand mit hohem Widerstand, wobei die zusätzliche Elektrode (7) von der primären Elektrode (6) elektrisch isoliert ist, und einen Zustand mit niedrigem Widerstand, wobei die zusätzliche Elektrode (7) in elektrischer Leitung mit der primären Elektrode (6) ist, anzunehmen, um die elektrisch aktive Oberfläche der zweiten Elektrode (5) ohne Variation der Ausrichtung der primären Elektrode (6) und der zusätzlichen Elektrode (7) bezüglich der ersten Elektrode (2) variieren zu lassen,
- einen zweiten Stapel, umfassend eine dritte Elektrode (17) und eine vierte Elektrode (14), gegenüberliegend der dritten Elektrode (17), und eine Zone aus einem dielektrischen Material, die zwischen der dritten und der vierten Elektrode angeordnet ist, wobei die vierte Elektrode (14) einerseits von einer primären Elektrode aus einem elektrisch leitenden Material und andererseits von einer zusätzlichen Elektrode, umfassend ein Material mit Zustandsveränderung, des zweiten Stapels gebildet wird, wobei die primäre Elektrode und die zusätzliche Elektrode der vierten Elektrode (14) jeweils gegenüberliegend der dritten Elektrode (17) sind, wobei das Material mit Zustandsveränderung des zweiten Stapels zumindest zum Teil in Kontakt mit der primären Elektrode der vierten Elektrode (14) angeordnet ist und dazu konfiguriert ist, alternierend einen Zustand mit hohem Widerstand, wobei die zusätzliche Elektrode der vierten Elektrode (14) von der primären Elektrode der vierten Elektrode (14) elektrisch isoliert ist, und einen Zustand mit niedrigem Widerstand, wobei die zusätzliche Elektrode der vierten Elektrode (14) in elektrischer Leitung mit der primären Elektrode der vierten Elektrode (14) ist, anzunehmen, um die elektrisch aktive Oberfläche der vierten Elektrode (17) ohne Variation der Ausrichtung der primären Elektrode der vierten Elektrode (14) und der zusätzlichen Elektrode der vierten Elektrode (14) bezüglich der dritten Elektrode (17) variieren zu lassen,

und wobei der Teil der ersten Elektrode (2) des ersten Stapels, der gegenüberliegend der zusätzlichen Elektrode des ersten Stapels ist, die primäre Elektrode des zweiten Stapels bildet,
und wobei die zweite Elektrode (5) des ersten Stapels einen Teil der dritten Elektrode bildet, der gegenüberliegend der primären Elektrode des zweiten Stapels ist.

**16.** Kondensator nach dem vorhergehenden Anspruch, wobei die erste Elektrode (2) des ersten Stapels eine erste Schicht aus elektrisch leitendem Material (3) und eine zweite Schicht aus elektrisch leitendem Material (4), die so elektrisch verbunden sind, dass der Teil der dritten Elektrode (5) des zweiten Stapels eingefasst wird, der gegenüberliegend der primären Elektrode des zweiten Stapels ist, und eine Zone aus dielektrischem Material (10) umfasst, und wobei die primäre Elektrode des zweiten Stapels von der zweiten Schicht aus elektrisch leitendem Material (4) der ersten Elektrode (2) des ersten Stapels gebildet wird.

**17.** Kondensator nach einem der zwei vorhergehenden Ansprüche, wobei ein Teil der dritten Elektrode (17), der gegenüberliegend der zusätzlichen Elektrode des zweiten Stapels ist, mit der primären Elektrode (6) des ersten Stapels so elektrisch verbunden ist, dass die vierte Elektrode (14) des zweiten Stapels eingefasst wird.

**18.** Verfahren zur Variation der Kapazität eines Kondensators mit variabler Kapazität nach einem der Ansprüche 1 bis 9, **dadurch gekennzeichnet, dass** es die Anwendung eines Signals zur Steuerung des Zustands des Materials mit Zustandsveränderung (8) umfasst, so dass es von einem Zustand mit hohem Widerstand, wobei die zusätzliche Elektrode (7) von der primären Elektrode (6) elektrisch isoliert ist, in einen Zustand mit niedrigem Widerstand, wobei die zusätzliche Elektrode (7) in elektrischer Leitung mit der primären Elektrode (6) ist, übergehen gelassen wird, um die elektrisch aktive Oberfläche der zweiten Elektrode (5) und in der Tat die Kapazität des Kondensators zu variieren.

**19.** Verfahren nach dem vorhergehenden Anspruch, wobei die Anwendung eines Steuersignals eine begrenzte Dauer zur Veränderung des Zustands des Materials mit Zustandsveränderung (8) aufweist, wobei das letztere bistabil ist.

**20.** Verfahren nach einem der zwei vorhergehenden Ansprüche bei Abhängigkeit von Anspruch 2, wobei das Steuersignal eine Potentialdifferenz ist, die zwischen der Schicht aus elektrisch leitendem Material der primären Elektrode (6) und der Schicht aus elektrisch leitendem Material (9) der zusätzlichen Elektrode (7) angewendet wird.

**21.** Verfahren nach einem der Ansprüche 18 oder 19, wobei das Steuersignal eine Erhitzung des Materials mit Zustandsveränderung (8) ist, die von einer Wärmequelle erzeugt wird.

**22.** Verfahren nach dem vorhergehenden Anspruch, wobei die Wärmequelle eine Lichtquelle ist.

**Claims**

**1.** Variable-capacitance electrical capacitor comprising at least a first stack including a first electrode (2) and a second electrode (5) facing the first electrode (2) and an area of a dielectric material (10) disposed between said first and second electrodes (2, 5), the second electrode (5) comprising, on the one hand, a primary electrode (6) made of an electrically conducting material and, on the other hand, an additional electrode (7) comprising a state-change material (8), the primary electrode (6) and the additional electrode (7) being configured so as to be respectively facing the first electrode (2) in an unvarying orientation, during the operation of the capacitor, relative to the first electrode (2), said state-change material (8) being disposed such that it is at least partially in contact with the primary electrode (6) and configured to alternately assume a high resistance state in which the additional electrode (7) is electrically insulated from the primary electrode (6) and a low resistance state in which the additional electrode (7) is electrically conducting with the primary electrode (6) so as to vary the electrically active surface area of the second electrode (5) without varying the orientation of the primary electrode (6) and of the additional electrode (7) relative to the first electrode (2).

**2.** Capacitor according to the preceding claim, wherein the additional electrode (7) comprises a layer of electrically conducting material (9) disposed such that the state-change material (8) is placed at least partially between the primary electrode (6) and the layer of electrically conducting material (9) of the additional electrode (7) in a direction through the thickness of the first stack.

**3.** Capacitor according to any one of the preceding claims, wherein the primary electrode (6) and the additional electrode (7) have superimposed surfaces in contact with one another.

**4.** Capacitor according to any one of the preceding claims, wherein the first electrode (2) comprises a first layer of electrically conducting material (3) and a second layer of electrically conducting material (4) electrically connected to one another so as to encase the area of dielectric material (10), which itself encases the second electrode (5).

**5.** Capacitor according to any one of claims 1 to 3, wherein the primary electrode (6) and the additional electrode (7) are at least partially in one and the same plane.

**6.** Capacitor according to any one of the preceding claims, wherein the state-change material (8) comprises a discontinuous layer forming patches (11) placed in a dielectric material array.

**7.** Capacitor according to the preceding claim, wherein the primary electrode (6) is a discontinuous layer configured to allow at least partial overlap with the discontinuous layer of state-change material (8).

**8.** Capacitor according to any one of the preceding two claims, in combination with claim 2, wherein the layer of electrically conducting material (9) of the additional electrode (7) is a discontinuous layer configured to allow at least partial overlap with the discontinuous layer of state-change material (8).

**9.** Capacitor according to any one of the preceding claims, wherein the state-change material (8) is a bistable material.

**10.** Device comprising a capacitor according to any one of the preceding claims, and means for controlling the state of the state-change material (8).

11. Device according to the preceding claim when dependent on claim 6, comprising independent control means for each patch (11).

12. Device according to any one of the preceding two claims, when dependent on claim 2, wherein the control means are adapted to apply a potential difference between the primary electrode (6) and the layer of electrically conducting material (9) of the additional electrode (7).

13. Device according to any one of claims 10 or 11, wherein the control means comprise a heat source configured to generate heating of the state-change material (8).

14. Device according to the preceding claim, wherein the heat source comprises a light source.

15. Variable-capacitance electrical capacitor comprising at least:

- a first stack including a first electrode (2) and a second electrode (5) facing the first electrode (2) and an area of a dielectric material (10) disposed between said first and second electrodes (2, 5), in which first stack the second electrode (5) comprises, on the one hand, a primary electrode (6) made of an electrically conducting material and, on the other hand, an additional electrode (7) comprising a state-change material (8), the primary electrode (6) and the additional electrode (7) being respectively configured so as to be facing the first electrode (2) in an unvarying orientation, during the operation of the capacitor, relative to the first electrode (2), said state-change material (8) being disposed such that it is at least partially in contact with the primary electrode (6) and configured to alternately assume a high resistance state in which the additional electrode (7) is electrically insulated from the primary electrode (6) and a low resistance state in which the additional electrode (7) is electrically conducting with the primary electrode (6) so as to vary the electrically active surface area of the second electrode (5) without varying the orientation of the primary electrode (6) and of the additional electrode (7) relative to the first electrode (2),
- a second stack comprising a third electrode (17) and a fourth electrode (14) facing the third electrode (17) and an area of a dielectric material disposed between said third and fourth electrodes, the fourth electrode (14) is formed, on the one hand, by a primary electrode made of an electrically conducting material and, on the other hand, by an additional electrode comprising a state-change material of the second stack, the primary electrode and the additional electrode of the fourth electrode (14) being respectively facing the third electrode (17), said state-change material of the second stack being disposed such that it is at least partially in contact with the primary electrode of the fourth electrode (14) and being configured to alternately assume a high resistance state in which the additional electrode of the fourth electrode (14) is electrically insulated from the primary electrode of the fourth electrode (14) and a low resistance state in which the additional electrode of the fourth electrode (14) is electrically conducting with the primary electrode of the fourth electrode (14) so as to vary the electrically active surface area of the fourth electrode (17) without varying the orientation of the primary electrode of the fourth electrode (14) and of the additional electrode of the fourth electrode (14) relative to the third electrode (17),

and wherein the part of the first electrode (2) of the first stack which is facing the additional electrode of the first stack forms the primary electrode of the second stack and wherein the second electrode (5) of the first stack forms a part of the third electrode which is facing the primary electrode of the second stack.

16. Capacitor according to the preceding claim, wherein the first electrode (2) of the first stack comprises a first layer of electrically conducting material (3) and a second layer of electrically conducting material (4) electrically connected to one another so as to encase the part of the third electrode (5) of the second stack facing the primary electrode of the second stack and an area of dielectric material (10), and wherein the primary electrode of the second stack is formed by the second layer of electrically conducting material (4) of the first electrode (2) of the first stack.

17. Capacitor according to any one of the preceding two claims, wherein a part of the third electrode (17) which is facing the additional electrode of the second stack is electrically connected to the primary electrode (6) of the first stack, so as to encase the fourth electrode (14) of the second stack.

18. Method for varying the capacitance of a variable-capacitance capacitor according to any one of claims 1 to 9, **characterised in that** it comprises applying a control signal for controlling the state of the state-change material (8) so as to change it from a high resistance state in which the additional electrode (7) is electrically insulated from the primary electrode (6) to a low resistance state in which the additional electrode (7) is electrically conducting with the primary electrode (6) so as to vary the electrically active surface area of the second electrode (5) and hence the capacitance of the capacitor.

19. Method according to the preceding claim, wherein the duration of the application of a control signal is limited to the change of state of the state-change material (8), the latter being bistable.

20. Method according to any one of the preceding two claims, when dependent on claim 2, and wherein the control signal is a potential difference applied between the layer of electrically conducting material of the primary electrode (6) and the layer of electrically conducting material (9) of the additional electrode (7).

21. Method according to any one of claims 18 or 19, wherein the control signal is a heating of the state-change material (8) generated by a heat source.

22. Method according to the preceding claim, wherein the heat source is a light source.

**Figure 1**

**Figure 2**

**Figure 3**

**Figure 4**

**Figure 5**

**Figure 6**

**Figure 7**

**Figure 8**

**Figure 9**

**Figure 10**

**EP 3 032 598 B1**

**RÉFÉRENCES CITÉES DANS LA DESCRIPTION**

**Documents brevets cités dans la description**

- US 6977198 B1
- US 20120280393 A1
- WO 2009128048 A